# EUROPÄISCHE PATENTANMELDUNG

(11) **EP 1 304 747 A2**
(43) Veröffentlichungstag der Anmeldung: **23.04.2003**
(21) Anmeldenummer: 02023683.2
(22) Anmeldetag: 22.10.2002
(51) Int. Cl.: H01L 31/042, H01L 31/052, H01L 31/0216

(54) **Solarzellenmodul**

(30) Priorität: 22.10.2001 DE 10151966
(71) Anmelder: Deutsche Aerosol GmbH, 93093 Donaustauf (DE)
(72) Erfinder: Czech, Manuel, 93093 Donaustauf (DE); Hennel, Paul, 93173 Wenzenbach (DE)
(74) Vertreter: Haft, von Puttkamer, Berngruber, Czybulka

(57) **Zusammenfassung**

Es wird ein Solarmodul mit mehreren Solarzellen vorgeschlagen, bei dem ein Teil der Solarzellen (2) auf einer Grundfläche (4) angeordnet ist und ein weiterer Teil der Solarzellen (2) auf zumindest einer weiteren Fläche (3) angeordnet ist, welche in vorbestimmtem Winkel und Abstand aus der Grundfläche (4) herausragt, derart, dass die effektive Solarzellenfläche, bezogen auf eine definierte Solarmodulfläche erhöht wird.

## Beschreibung

Die vorliegende Erfindung betrifft ein Solarmodul, insbesondere für eine Photovoltaikanlage gemäß dem Oberbegriff des Patentanspruchs 1.

Heutzutage gewinnen neue Formen der Energiegewinnung zunehmend an Bedeutung, da dadurch die Umwelt nicht belastet und gleichzeitig die Ressourcen immer zur Verfügung stehen. Unter den sogenannten erneuerbaren oder regenerativen Energien ist die Solarenergie von besonderer Bedeutung, was auch durch die steigende Anzahl der installierten Solaranlagen verdeutlicht wird. Dies liegt unter anderem darin, dass die Umwandlung von Sonnenenergie in Elektrizität ohne schädliche Nebeneffekte, wie beispielsweise Umweltverschmutzung und Lärm erfolgt. Zudem weisen Solaranlagen keine beweglichen Teile auf und erfordern einen minimalen Wartungsaufwand.

Kernstück der Solaranlagen sind die Solarzellen, wobei es unterschiedliche Arten von Solarzellen auf dem Markt gibt. Beispielsweise sind monokristalline Monosolarzellen mit einem Wirkungsgrad von bis zu 17 % oder auch polykristalline Siliziumsolarzellen, die einen Wirkungsgrad der Größenordnung 14 % aufweisen, bekannt.

Die typische Leistung einer herkömmlichen Solarzelle mit einer Größe von 100 x 100 mm liegt bei 1,5 Watt. Aufgrund der relativ geringen Leistung einer einzelnen Solarzelle werden mehrere Solarzellen zu Solarmodulen zusammengefasst.

Nach dem Stand der Technik besteht ein Solarmodul aus mehreren Solarzellen, die aneinander angeschlossen sind und zwischen zwei Glas- oder Kunststoffscheiben eingebettet sind. Typische Werte für ein Solarmodul sind 36 Solarzellen, die in mehreren Reihen à 12 Zellen angeordnet sind. Hierbei liegen die Oberflächen der Solarzellen in einer Ebene. Der Wirkungsgrad eines Solarmoduls hängt folglich nur von dem Wirkungsgrad der einzelnen Solarzellen ab. Aus diesem Grunde wir heutzutage Versucht, neue Solarzellen zu entwickeln, was in höheren Entwicklungs- und Herstellungskosten resultiert.

Der vorliegenden Erfindung liegt die Aufgabe zugrunde, ein Solarmodul zur Verfügung zu stellen, welches im Vergleich zu herkömmlichen Solarmodulen einen höhere Energieausbeute aufweist und herkömmliche Solarzellen verwendet.

Des weiteren soll das erfindungsgemäße Solarmodul robust und stabil ausgebildet sein und eine effektive Temperierung ermöglichen.

Diese Aufgabe wird durch die Merkmale des kennzeichnenden Teils des Patentanspruchs 1 gelöst. Weitere Ausgestaltungen gehen aus den Unteransprüchen hervor.

Demnach wird vorgeschlagen, die Solarzellen in dem Solarmodul derart anzuordnen, dass die effektive Solarzellenfläche, bezogen auf eine definierte Solarmodulfläche erhöht wird. Dies wird dadurch erreicht, dass ein Teil der Solarzellen auf einer Grundfläche angeordnet ist und dass ein weiterer Teil der Solarzellen auf zumindest einer weiteren Fläche angeordnet ist, welche in vorbestimmtem Winkel und Abstand aus der Grundfläche herausragt.

Im Rahmen einer bevorzugten Ausführungsform sind die Solarzellen einem oder mehreren Trägern angeordnet, wobei jeder Träger im Querschnitt einem nach oben offenen Trapez entspricht, und auf dessen der Lichteinstrahlung zugewandten Seitenflächen Solarzellen vorgesehen sind.

Zusätzliche Solarzellen sind auf der Grundfläche der Träger vorgesehen, bevorzugterweise in einer bezüglich der Längsachse mittigen Anordnung. Die Struktur eines Trägers ist demnach die Struktur eines nach oben offenen, der Lichteinstrahlung zugewandten Keils, so dass sich keilförmige dreidimensionale Gebilde, deren Länge abhängig von der Größe des Solarmoduls ist, bilden. Die Fläche des Solarmoduls kann durch aneinander gereihte derartige Träger beliebig gestaltet werden.

Um das einfallende Licht auch auf die auf der Grundfläche der Träger angeordneten Solarzellen zu richten und so die Energieausbeute des Moduls weiter zu erhöhen, werden gemäß der Erfindung Spiegelelemente eingesetzt.

Als besonders vorteilhaft erweist sich auch die alternative oder zusätzliche Verwendung eines Deckels für das Solarmodul, welcher so ausgebildet ist, dass das einfallende Licht auch Flächen der auf der Grundfläche angeordneten Solarzellen erreicht, die dem Licht nicht direkt zugänglich sind. Bevorzugterweise weist der Deckel eine zweidimensionale Linsenfunktion auf.

Des weiteren wird vorgeschlagen, die einzelnen Solarzellen des erfindungsgemäßen Solarmoduls einer zusätzlichen Oberflächenbehandlung zu unterziehen, um die durch die interne Feuchtigkeit verursachten Verluste durch eine Inaktivierung der Wasser- bzw. Feuchtigkeitsdipole entlang der Zellenoberfläche zu reduzieren. Hierbei werden zwei lichtdurchlässige Dünnschichten aufgetragen; die erste Schicht ist eine Schicht, die geeignet ist, die Wasserdipole zu verankern, bevorzugterweise mit anfangs flüssigem Silan und die zweite Schicht eine Schutzschicht, beispielsweise Polyurethan oder Polyester. Durch den physikalischen Austrocknungseffekt, der durch die aufgetragene Silanschicht erzeugt wird, wird eine Verankerung der Wasserdipole erzielt. Dies bedeutet, dass eine Rotation der Dipole um die eigene Achse vermieden wird. Dadurch wird zum einen eine Erhöhung der Zellentemperatur aufgrund der Umwandlung der Rotationsenergie in unerwünschte thermische Energie und der Umwandlung der Solarenergie in kinetische Energie vermieden und zum anderen die unerwünschte elektrische Leifähigkeit durch die Dipolanordnung reduziert. In einigen Fällen kann es zweckmäßig sein, lediglich die erste silanhaltige aufzutragen, wenn beispielsweise eine Schutzschicht ohnehin vorgesehen ist. Zudem kann die silanhaltige Schicht ganzoder teilweise die Solarzellen bedecken, da zur Unterbrechung der Leitfähigkeit eine teilweise Beschichtung ausreicht.

Üblicherweise wird nach dem Stand der Technik versucht, die Feuchtigkeit zu eliminieren, indem unter Vakuumbedingungen und Hochtemperaturverarbeitung die Feuchtigkeit reduziert wird. Diese Vorgehensweise ist jedoch mit hohen Kosten und erhöhtem Aufwand verbunden.

Ein weiterer Vorteil der erfindungsgemäßen Konstruktion besteht darin, dass die Bauweise eine Temperierung des Solarmoduls ermöglicht. Hierbei kann es sich um einen offenen oder einen geschlossenen Kreislauf handeln, wobei in Abhängigkeit von den Betriebsbedingungen ein thermischer Rücklauf realisierbar ist.

Der Rücklauf kann auch außerhalb des Solarmoduls angeordnet sein; zudem kann auch anstelle von Luft auch eine Gasmischung verwendet werden (enthalpisches System).

Im folgenden wird die Erfindung anhand einer bevorzugten Ausführungsform, die Gegenstand der beigefügten Figuren ist, näher erläutert.
Figur 1 ist eine schematische Schnittansicht eines Trägers für die Solarzellen gemäß der Erfindung;
Figur 2 ist eine beispielhafte Darstellung der durch die vorliegende Erfindung erzielten optimierten Temperierung des erfindungsgemäßen Solarmoduls; und
Figur 3 ist eine schematische Darstellung der Beschichtung der Solarzellen gemäß der Erfindung.

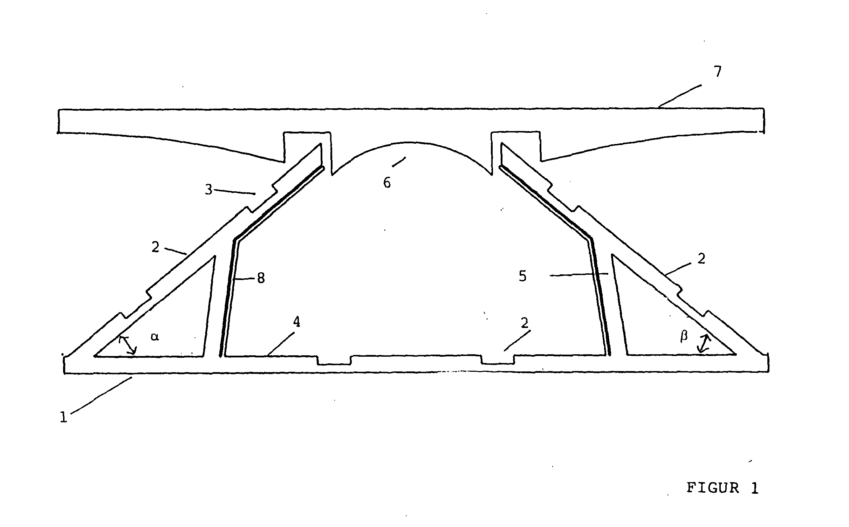

In Figur 1 ist eine schematische Schnittansicht eines Trägers 1 für die Solarzellen 2 in einem erfindungsgemäßen Solarmodul. Der Querschnitt entspricht einem nach oben offenen - vorliegenden Fall einem gleichschenkligen - Trapez. Der Träger 1 weist drei mit Solarzellen versehene Flächen auf, nämlich die der Lichteinstrahlung zugewandten Seitenflächen 3 und die Grundfläche 4. Die Solarzellen der Grundfläche 4 sind bevorzugterweise bezüglich der Längsachse mittig angeordnet. Die Winkel α,β zwischen den Seitenflächen und der Grundfläche können beliebige Werte annehmen, typische Werte liegen zwischen 40° und 50°. Vorteilhafterweise sind beide Winkel gleich, obwohl - je nach Bedarf - weitere Ausgestaltungen möglich sind.

Des weiteren sind optional Stützwände 5 vorgesehen, um die Seitenflächen 3 zu stützen und eine bessere Klimatisierung bzw. Temperierung zu gewährleisten.

Das Licht kann durch die Öffnung 6 zwischen den Seitenflächen 3 in den durch die Seitenflächen 3, die Stützwände 5, für den Fall, dass Stützwände vorgesehen sind, und die Grundfläche 4 gebildeten Raum eintreten und auf den zentralen Teil der auf der Grundfläche angeordneten Solarzelle 2 einfallen. Der restliche Teil der Solarzelle 2, d. h. die von der Längsachse entfernten Seiten, werden ebenfalls vom einfallenden Licht beleuchtet, jedoch mit geringerer Intensität. Um die Lichtkinematik zu optimieren, wird im Rahmen der vorliegenden Erfindung vorgeschlagen, den Deckel 7 des Solarmoduls derart auszubilden, dass der Deckelabschnitt zumindest über der Öffnung 6 Linseneigenschaften aufweist, um so das einfallende Licht auf die beiden Seiten der auf der Grundfläche angeordneten Solarzellen zu verteilen. Hierbei ist der Deckel vorzugsweise aus Glas, Plexiglas oder Kunststoff hergestellt.

Um die auf der Grundfläche angeordneten Solarzellen 2 besser mit Licht zu versorgen, werden gemäß der Erfindung die dem Innenraum des durch die Seitenflächen 3, die Stützwände 5, für den Fall, dass Stützwände vorgesehen sind, und die Grundfläche 4 gebildeten Raumes zugewandten Seiten der Stützwände 5 und der Seitenflächen 3 ganz oder teilweise mit Spiegelelementen 8 versehen. Auf diese Weise wird das auf die Spiegelelemente einfallende Licht reflektiert und auf die Solarzelle 2 gerichtet.

Durch diese beschriebenen geometrischen und konstruktiven Maßnahmen wird die aktive Fläche, die der Lichtstrahlung zugänglich ist, wesentlich erhöht. Ein typischer Wert dafür beträgt ca. 50 %.

Zudem wird das einfallende Licht und das Reflexionslicht optimal ausgenutzt bei einer gleichzeitigen Vermeidung von bifacialen Solarzellen, die mit sehr hohen Kosten verbunden sind. Ein weiterer Vorteil der vorgestellten geometrischen Anordnung der Solarzellen besteht darin, dass sich Kanäle für Luft- bzw. ein weiteres Kühlmedium bilden. Hierbei kann der Rücklauf außerhalb des erfindungsgemäßen Solarmoduls vorgesehen sein.

Zur Klimatisierung ist sowohl ein offenes als auch ein geschlossenes System denkbar. Zudem ist auch als Kühlmedium ein Gasgemisch vorstellbar, welches zum Teil als enthalpisches System wirkt.

Gemäß einer weiteren Ausführungsform ist auch eine Lamellentemperierung vorgesehen; zu diesem Zweck können an der Rückseite der Seitenflächen 3 Kühlrippen vorgesehen sein.

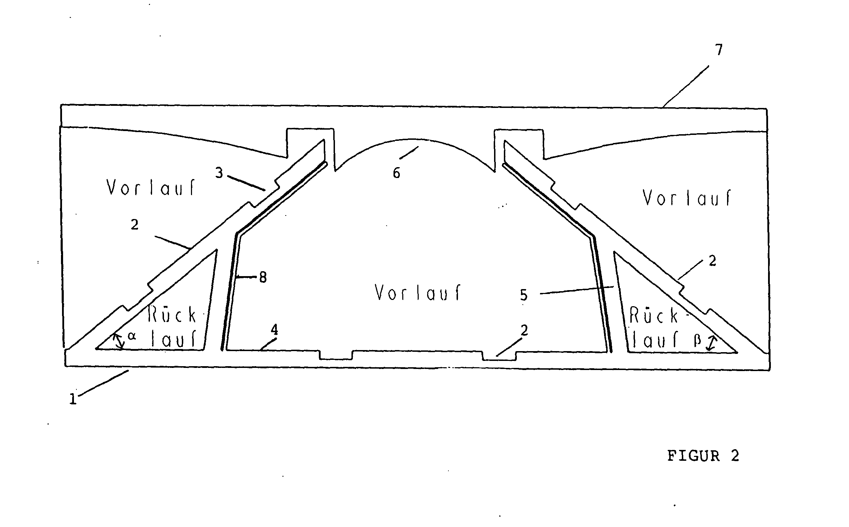

In Figur 2 werden die durch die geometrische Konstruktion entstehenden Kühlkanäle (Vorlauf, Rücklauf) dargestellt.

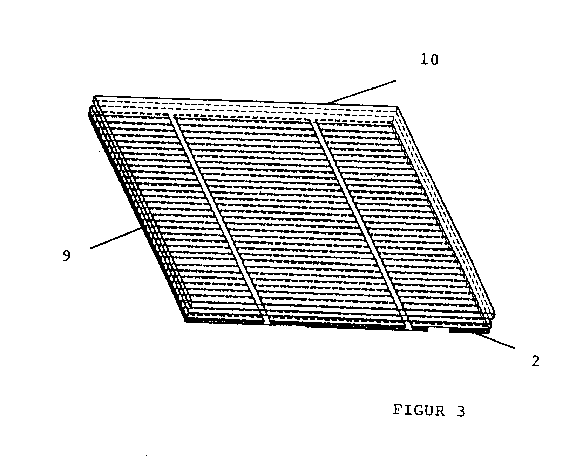

Im Rahmen der Erfindung wird die Solarzellenoberfläche zusätzlich behandelt, um eine Verankerung der Wasserdipole bzw. der Feuchtigkeitsdipole auf der Oberfläche der Solarzellen zu erzielen. Hiermit wird eine Energieabsorption sowie eine anschließende Energieabgabe in Form von Wärme, die den Wirkungsgrad einer Solarzelle beeinträchtigt, vermieden. Zu diesem Zweck wird die Oberfläche der Solarzellen einer Oberflächenbehandlung mit einer oder zwei lichtdurchlässigen Dünnschichten unterzogen. Die erste Schicht 9 ist eine Verbindungsschicht, die ein Silan enthält und die zweite, optionale Schicht 10 eine Schutzschicht, die bevorzugter Weise aus Polyurethan, Polyester oder aus einem weiteren lichtdurchlässigen Lackmaterial sein kann. Dies wird in Figur 3 verdeutlicht. Wie bereits erläutert, reicht eine teilweise Beschichtung mit der silanhaltigen Schicht aus, um die unerwünschte Leitfähigkeit signifikant zu reduzieren.

Selbstverständlich kann diese Beschichtung auch vorteilhafterweise auf Solarzellen angewandt werden, die nach dem Stand der Technik, beispielsweise in einer Ebene angeordnet sind, da die daraus resultierenden verbesserten Eigenschaften unabhängig von der geometrischen Anordnung der Solarzellen sind.

Die hier vorgestellte Konstruktion erweist sich außerdem als äußerst robust und stabil. Des weiteren werden die Herstellungskosten gering gehalten, da herkömmliche Solarzellen verwendet werden und der vorgesehene Deckel mit Linseneigenschaften ohne besonderen Aufwand mit herkömmlichen Verfahren hergestellt werden kann.

## Patentansprüche

1. Solarmodul mit mehreren Solarzellen, **dadurch gekennzeichnet, dass** ein Teil der Solarzellen (2) auf einer Grundfläche (4) angeordnet ist und dass ein weiterer Teil der Solarzellen (2) auf zumindest einer weiteren Fläche (3) angeordnet ist, welche in vorbestimmtem Winkel und Abstand aus der Grundfläche (4) herausragt, derart, dass die effektive Solarzellenfläche, bezogen auf eine definierte Solarmodulfläche erhöht wird.

2. Solarmodul nach Anspruch 1, **dadurch gekennzeichnet, dass** die Solarzellen (2) auf mindestens einem Träger (1) angeordnet sind, der mindestens drei mit Solarzellen (2) versehene Flächen (3, 4) aufweist, wobei jeder Träger (1) im Querschnitt einem nach oben offenen Trapez entspricht, und auf dessen der Lichteinstrahlung zugewandten Seitenflächen (3) Solarzellen vorgesehen sind, wobei auf dessen Grundfläche (1) Solarzellen (2) bezüglich der Längsachse mittig angeordnet sind, sodass die einzelnen Träger (1) einen nach oben offenen Keil bilden.

3. Solarmodul nach Anspruch 1, **dadurch gekennzeichnet, dass** der Querschnitt der einzelnen Träger (1) ein gleichschenkliges Trapez bildet.

4. Solarmodul nach einem der Ansprüche 1, 2 oder 3, **dadurch gekennzeichnet, dass** Stützwände (5) vorgesehen sind, um die Seitenflächen (3) zu stützen.

5. Solarmodul nach einem der vorangehenden Ansprüche, **dadurch gekennzeichnet, dass** das Solarmodul an der der Lichteinstrahlung zugewandten Seite einen Deckel (7) aufweist, der zumindest im Bereich der Öffnung (6) zwischen den beiden Seitenflächen linsenförmig ausgebildet ist und Linseneigenschaften aufweist, um das Licht auf die Seiten der auf der Grundfläche (4) angeordneten Solarzelle (2) zu richten.

6. Solarmodul nach einem der vorangehenden Ansprüche, **dadurch gekennzeichnet, dass** die dem Innenraum des aus den Seitenflächen (3) und den Stützwänden (5) gebildeten Hohlraumes zugewandten Seiten der Stützwände und der Seitenflächen ganz oder teilweise mit Spiegelelementen (8) versehen sind.

7. Solarmodul nach einem der vorangehenden Ansprüche, **dadurch gekennzeichnet, dass** die Solarzellen (2) des Solarmodules ganz oder teilweise mit einer Schicht (9) beschichtet sind, die eine Verankerung der Wasserdipole auf der Solarzellenoberfläche bewirkt.

8. Solarmodul nach Anspruch 7, **dadurch gekennzeichnet, dass** diese Schicht (9) eine lichtdurchlässige Schicht ist, die ein Silan enthält.

9. Solarmodul nach Anspruch 7 oder 8, **dadurch gekennzeichnet, dass** auf der Schicht (9) eine lichtdurchlässige Schutzschicht (10) vorgesehen ist.

10. Solarmodul nach Anspruch 9, **dadurch gekennzeichnet, dass** die Schutzschicht (10) aus Polyurethan, Polyester oder aus einem weiteren geeigneten lichtdurchlässigen Material gebildet ist.

11. Solarmodul nach einem der vorangehenden Ansprüche, **dadurch gekennzeichnet, dass** an den Rückseiten der Seitenflächen (3) Kühlrippen vorgesehen sind.

12. Solarmodul nach einem der vorangehenden Ansprüche, **dadurch gekennzeichnet, dass** eine geschlossene oder offene Klimatisierung vorgesehen ist.

13. Verwendung einer ein Silan enthaltenden Schicht als zusätzliche zumindest teilweise Beschichtung von Solarzellen in einem Solarmodul zur Verankerung der Wasserdipole auf der Solarzellenoberfläche.

14. Verwendung einer Schicht nach Anspruch 13 zur Beschichtung der Solarzellen in einem Solarmodul nach einem der Ansprüche 1 bis 12.
